# EUROPÄISCHE PATENTSCHRIFT

(11) **EP 2 647 737 B1**
(45) Veröffentlichungstag und Bekanntmachung des Hinweises auf die Patenterteilung: **18.04.2018**
(21) Anmeldenummer: 13159669.4
(22) Anmeldetag: 18.03.2013
(51) Int. Cl.: C22C 5/06, C22C 1/02, C23C 14/34, H01J 37/34

(54) **Planares oder rohrförmiges Sputtertarget sowie Verfahren zur Herstellung desselben**
Planar or tubular sputter target and method for producing the same
Cible de pulvérisation planaire ou tubulaire et son procédé de fabrication

(30) Priorität: 04.04.2012 DE 102012006718
(43) Veröffentlichungstag der Anmeldung: 09.10.2013
(73) Patentinhaber: Materion Advanced Materials Germany GmbH, 63450 Hanau (DE)
(72) Erfinder: Schlott, Martin, 63075 Offenbach (DE); Schneider-Betz, Sabine, 63303 Dreieich (DE); Konietzka, Uwe, 63826 Geiselbach (DE); Schultheis, Markus, 36103 Flieden (DE); Kahle, Ben, 63755 Alzenau (DE); Ebel, Lars, 63579 Freigericht (DE)
(74) Vertreter: Kador & Partner

(56) Entgegenhaltungen:
- EP-A1- 1 331 280
- WO-A1-2011/043486
- DE-A1- 10 336 228
- DE-B4- 10 392 142

## Beschreibung

Die vorliegende Erfindung betrifft ein planares Sputtertarget mit einer Fläche von mehr als 0,3 m² oder ein rohrförmiges Sputtertargets mit einer Länge von mindestens 1,0 m, jeweils bestehend aus einer Silberbasislegierung mit mindestens einer weiteren Legierungskomponente ausgewählt aus Indium, Zinn, Antimon und Wismut mit einem Gewichtsanteil von zusammen 0,01 bis 5,0 Gew.-%.
Weiterhin betrifft die Erfindung ein Verfahren zur Herstellung eines planaren Sputtertargets mit einer Fläche von mehr als 0,3 m² oder eines rohrförmigen Sputtertargets mit einer Länge von mindestens 1,0 m aus einer Silberbasislegierung, umfassend das Schmelzen einer Legierung mit einer nominalen Zusammensetzung von Silber und mindestens einer weiteren Legierungskomponente ausgewählt aus Indium, Zinn, Antimon und Wismut mit einem Gewichtsanteil von zusammen 0,01 bis 5,0 Gew.-%, Gießen der Schmelze in eine Form unter Bildung eines Formkörpers aus der Silberbasislegierung und Umformen des Formkörpers zu dem Sputtertarget.
Derartige Sputtertargets werden als Kathodenmaterial zur Herstellung von Schichten mittels hochvakuumbasierter Materialzerstäubung in rohrförmiger und planarer Bauform eingesetzt, wie etwa quadratische Targets oder Streifentargets. Mittels Kathodenzerstäubung werden beispielsweise optische Speichermedien oder Substrate bei der Herstellung von Flüssigkristallbildschirmen oder OLED-Displays mit reflektierenden oder teilreflektierenden Schichten versehen.

### Stand der Technik

Ein Sputtertarget zur Herstellung von Schichten mit hohem Reflexionsvermögen im sichtbaren Spektralbereich ist aus der EP 1 489 193 A1 bekannt. Das Target-material besteht aus einer Silber-Legierung mit Zusätzen von 0,01 - 5,0 Gew.-% wobei mindestens eines der Elemente Indium, Zinn, Antimon und/oder Wismut enthalten ist. Dieser Werkstoff zeichnet sich durch hohe Korrosions- und Witterungsbeständigkeit in schwefelhaltiger Atmosphäre aus.
Die Herstellung erfolgt in der Regel durch Aufschmelzen einer Legierung und Gießen in eine Form, häufig gefolgt von einem Umformschritt, etwa durch Schmieden, Walzen, oder Pressen.

Aus der EP 1 331 280 A1 ist ein Verfahren zur Herstellung eines Silberrohlings sowie eines Rohrtargets bekannt. Der Silberrohling hat einen Silbergehalt von ≥ 99,99 Gew.-% und einen Sauerstoffgehalt < 20 ppm. Im Zuge der Herstellung werden 100 bis 500 ppm Kalzium oder Aluminium der Silberschmelze zugegeben.

Ein Sputtertarget aus einer Silberlegierung und ein Verfahren zur Herstellung desselben ist aus der DE 103 92 142 B4 bekannt, dessen durchschnittliche Kristallkorngröße vorzugsweise 100 µm oder weniger beträgt. Neben Silber als Basismaterial wird eines oder mehrere Legierungselemente von Nd, Seltenenerdenelement wie Y, Au, Cu, Ti oder Zn zugegeben.

Eine Silberlegierung zur Herstellung eines Elektrodenfilms ist in der WO 2011/043486 A1 offenbart. Die Legierung enthält 0,1 bis 1,5 Gew.-% In, und der verbleibende Anteil enthält Ag und unvermeidbare Verunreinigungen.

Die DE 103 36 228 betrifft einen Ag-Legierungsfilm, der insbesondere als reflektierender Film oder halbdurchlässiger reflektierender Film für ein optisches Informationsaufzeichnungsmedium mit hoher Wärmeleitfähigkeit / hoher Reflektionsfähigkeit / hoher Haltbarkeit auf dem Gebiet der optischen Informationsaufzeichnungsmedien verwendet wird. Der Ag-Legierungsfilm umfasst eine Legierung auf Ag-Basis, wobei der Gesamtgehalt an Bi und Sb 0,05 bis 10 Atomprozent beträgt.

### Technische Aufgabe

Im Zuge der Entwicklung immer größerer Flachbildschirme werden auch die Sputtertargets immer großflächiger. Gleichzeitig stellen sich zunehmend höhere Anforderungen an die Beschichtungsqualität, einerseits bedingt durch die großflächigeren Substrate und andererseits durch höhere Displayauflösungen, die kleinere Pixel erfordern. Fehler in der Beschichtung sind kaum akzeptabel, denn sie verursachen einen hohen Zeit- und Materialaufwand und machen sich daher produktionsmindernd bemerkbar. Einer höheren Produktionsrate durch Erhöhung der Leistungsdichte beim Sputterprozess sind Grenzen gesetzt, da es beim Abscheiden der Schichten zu Spritzern (*splashes*) kommen kann, deren Ursache lokale Funkenentladungen auf dem Target sind, die auch als *arcing* oder *micro arcing* bezeichnet werden. Durch die Funkenentladungen wird das Target-Material lokal aufgeschmolzen, so dass kleine geschmolzene Spritzer des Target-Materials auf das zu beschichtende Substrat gelangen und dort Defekte erzeugen, die die Funktion einzelner oder mehrerer Pixel beeinträchtigen können.
Derartige Funkenentladungen führen insbesondere bei der Herstellung großer und hochlauflösender Displays mit vergleichsweise kleinen Pixeln häufig zu Ausfällen.
Der Erfindung liegt daher die Aufgabe zugrunde, ein großflächiges Sputtertarget auf Basis einer Silber-Legierung bereitzustellen, das als planares Sputtertarget eine Fläche von mehr als 0,3 m² und als rohrförmiges Sputtertargets eine Länge von mindestens 1,0 m hat, und bei dem die Gefahr von Funkenentladungen verringert und damit ein Sputterprozess mit vergleichsweise hoher Leistungsdichte möglich ist.

Weiterhin liegt der Erfindung die Aufgabe zugrunde, ein Verfahren für eine kostengünstige Herstellung des Sputtertargets anzugeben.

### Allgemeine Beschreibung der Erfindung

Diese Aufgabe wird ausgehend von einem Sputtertarget der eingangs genannten Gattung erfindungsgemäß dadurch gelöst, dass die Silberbasislegierung ein Kristallgefüge mit einer mittleren Korngröße von weniger als 120 µm, einen Sauerstoffgehalt von weniger als 20 Gew.-ppm, einen Gehalt an Verunreinigungselementen von Aluminium, Lithium, Natrium, Calcium, Magnesium, Barium und Chrom von jeweils weniger als 0,5 Gew.-ppm, und eine metallische Reinheit von mindestens 99,99 Gew.-% aufweist.
Die Silberbasislegierung enthält mindestens eines der Elemente Indium, Zinn, Antimon und/oder Wismut mit einem Masseanteil von zusammen 0,01 bis 5,0 Gew.-%. Es hat sich gezeigt, dass bei einer derartigen Legierung die Kombination mehrerer Faktoren die Neigung zur Funkenentladung wesentlich bestimmt, nämlich der Gehalt an Sauerstoff und an den Verunreinigungselementen Aluminium, Lithium, Natrium, Calcium, Magnesium, Barium und Chrom sowie die Gefüge-Korngröße.
Im Hinblick auf eine geringe Neigung zur Funkenentladung ist ein geringer Sauerstoffgehalt der Legierung von weniger als 50 Gew.-ppm erforderlich. Herstellungsbedingt enthalten Sputtertargets jedoch einen gewissen Metalloxidbestandteil, der bei Silberbasislegierung beispielsweise von den eingesetzten Silbergranalien stammen kann, die häufig einen gewissen Anteil an Sauerstoff enthalten. Aber auch über andere Metalle mit hoher Affinität zu Sauerstoff tragen zum Sauerstoffeintrag in die Legierung bei, wie beispielsweise Aluminium, Lithium, Natrium, Calcium, Magnesium, Barium und Chrom. Daher ist in der erfindungsgemäßen Silberbasislegierung die Konzentration dieser Metalle gemessen mit GDMS auf jeweils weniger als 0,5 Gew.-ppm, vorzugsweise weniger als 0,1 Gew.-ppm, beschränkt.
Weiterhin hat sich gezeigt, dass insbesondere Verunreinigungen mit hoher Affinität zu Sauerstoff die Ursache von Funkenentladungen sein können, so dass erfindungsgemäß, die metallische Reinheit der Silberbasislegierung bei 99,99 Gew.-% oder höher liegt. Die hohe Reinheit schließt Verunreinigungen jeder Art aus.
Neben der stofflichen Zusammensetzung hat sich die Korngröße des Kristallgefüges als weiterer entscheidender Faktor in Bezug auf die Neigung zur Funkenentladungen erwiesen. Sie ist umso geringer, je feiner das Gefüge ist. Die erfindungsgemäße Silberbasislegierung zeichnet sich daher durch eine mittlere Korngröße (gemessen nach dem Linienschnittverfahren ASTM E112) von weniger als 120 µm, bevorzugt von weniger als 100 µm aus. Die Einstellung sehr geringer Korngrößen von weniger als 5 µm erfordert jedoch hohe Verformungsgrade und ist daher aufwändig.

Der Sauerstoffgehalt der Silberbasislegierung ist so gering wie möglich, d.h. unterhalb von 20 ppm, besonders bevorzugt unterhalb von 10 ppm. Eine Maßnahme, um dies zu erreichen, besteht darin, die oben genannten sauerstoffaffinen Verunreinigungselemente möglichst zu vermeiden, deren Gesamtgehalt in der Silberbasislegierung daher bei weniger als 0,5 ppm, vorzugsweise bei weniger als 0,1 ppm liegt.
Hinsichtlich des Verfahrens wird die oben angegebene Aufgabe erfindungsgemäß dadurch gelöst, dass ausgehend von einem Verfahren der eingangs genannten Gattung das Schmelzen durch Induktionsschmelzen unter reduzierend wirkenden Bedingungen und unter Einstellung eines Sauerstoffgehalts von weniger als 20 Gew.-ppm erfolgt.
Die Ausgangskomponenten für Silberbasislegierung liegen in Form hochreiner Metalle der jeweiligen Komponenten oder in Form von vorlegiertem Material vor. Der Gehalt an sauerstoffaffinen Verunreinigungselementen wie Aluminium, Lithium, Natrium, Calcium, Magnesium, Barium und Chrom liegt jeweils unter 0,5 Gew.-ppm, vorzugsweise unter 0,1 Gew.-ppm. Der anfängliche Sauerstoffgehalt der Ausgangskomponenten ist so gering wie möglich zu halten und kann vor dem Einschmelzen zusätzlich durch reduzierende Behandlung gesenkt werden.
Wesentlich im Sinn der Erfindung ist jedoch, dass während des Einschmelzprozesses reduzierend wirkende Bedingungen eingestellt werden. Diese Bedingungen können durch die Anwesenheit einer sauerstoffaffinen Substanz der Schmelzatmosphäre, der Schmelzform oder des Schmelzgutes erzeugt werden. Die Sauerstoffaffinität dieser Substanz ist höher als die der Legierungskomponenten der Silberbasislegierung, so dass sie vorhandenen Sauerstoff abfängt. Eine Bedingung "wirkt reduzierend" in diesem Sinne, wenn die sauerstoffaffine Substanz während des gesamten Schmelzprozesses oder mindestens während einer Phase des Schmelzprozesses sauerstoffabfangend wirkt.
Durch Induktionsschmelzen wird der Eintrag von Sauerstoff und anderen Verunreinigungen aus Brenngasen in die Metallschmelze vermieden.
Dadurch gelingt es, den Sauerstoffgehalt in der Silberbasislegierung auf weniger als 20 Gew.-ppm zu reduzieren. Außerdem sollte die sauerstoffaffine Substanz nicht in die Legierung gelangen. Dies ist am einfachsten dadurch zu erreichen, dass sie als Gas vorliegt oder mit Sauerstoff zu einem Gas reagiert, das in der Silberbasislegierung nicht oder schlecht löslich ist.
Im Hinblick hierauf hat es sich bewährt, wenn die reduzierend wirkenden Bedingungen durch Zusatz von Graphit erzeugt werden.
Graphit reagiert mit Sauerstoff zu Kohlendioxid oder zu Kohlenmonoxid. Beide Gase können aus der Metallschmelze entweichen. Graphit kann z.B. als Pulver zugesetzt werden, wobei die Menge so zu bemessen ist, dass es nach Abschluss des Schmelzprozesses vollständig aufgebraucht ist.
Im Hinblick auf die Einstellung eines möglichst feinkörnigen Gefüges erfolgt das Umformen des Formkörpers aus der Silberbasislegierung bei einer Temperatur im Bereich von 650 bis 750 °C unter dynamischer Rekristallisation des Kristallgefüges und unter Ausbildung einer mittleren Korngröße von weniger als 120 µm.

### Ausführungsbeispiel

Nachfolgend wird die Erfindung anhand von Ausführungsbeispielen näher erläutert.

### Versuchsergebnisse

In Versuchsreihen wurden zunächst mehrere Versuchs-Sputtertargets durch Induktionsschmelzen verschiedener Silberbasislegierungen in folgenden Bauformen und Abmessungen gefertigt:
a) planare, streifenförmige Targets mit den Abmessungen 488 mm x 88 mm und einer Oberfläche von 0,043 m², und
b) Rohrtargets mit einem Durchmesser von 155 mm und einer Länge von 505 mm.

In **Tabelle 1** sind die chemischen Zusammensetzungen der Versuchstargets und die damit erzielten Versuchsergebnisse zusammengefasst. "VU" bezeichnet dabei den Gesamtgehalt an den Verunreinigungen: Aluminium, Lithium, Natrium, Calcium, Magnesium, Barium und Chrom.

Die Sputtertargets der Versuche 1 bis 10 wurden durch Induktionsschmelzen von hochreinen Legierungskomponenten und mit unterschiedlichem Sauerstoffgehalt hergestellt. Zur Verringerung des Sauerstoff-Gehalts wurden die Metallschmelzen der Versuche 2, 3, 5, 8 und 10 einer Desoxidation durch Zugabe von Graphitpartikeln unterzogen.

### Herstellung der planaren Versuchs-Targets

Nach dem Gießen der Induktionsschmelze und dem Abkühlen der so erhaltenen Gussstücke wurden durch Warmwalzen 2,5 m lange Rohstreifen des Targetmaterials gefertigt. Eine besonders feine metallische Kornstruktur wird erhalten, wenn die Gussstücke bei Temperaturen von 650-750 °C in mehreren Stichen umgeformt und anschließend abgekühlt werden (dynamische Rekristallisation). Anschließend wurden die planaren Versuchs-Sputtertargets aus Streifen herausgeschnitten.

### Herstellung der rohrförmigen Versuchs-Targets

Zur Fertigung der rohrförmigen Versuchs-Targets wurden zylinderförmige Gussblöcke wie oben beschrieben durch Induktionsschmelzen hergestellt. Die Gussblöcke wurden anschließend gebohrt und durch Extrudieren in Rohre umgeformt. Hierbei ist zwischen einer Warmumformung und einer Kaltumformung zu unterscheiden. Bei der Warmumformung wird wie bei dem oben bereits erwähnten Warmwalzen eine besonders feine metallische Kornstruktur erhalten, wenn die Gussblöcke bei Temperaturen von 650-750°C umgeformt und anschließend abgekühlt werden. Alternativ hierzu kann auch eine Kaltumformung erfolgen, wobei dann eine nachfolgende Rekristallisationsglühung im Bereich von 400-600°C für 0,5 bis 4 Stunden je nach Umformungsgrad und Ausgangsgefüge erforderlich ist.

Mit den so erhaltenen Targets wurden die Sputter-Versuche unter den folgenden Bedingungen durchgeführt:

Der Sputter-Druck betrug 0,5 Pa. Die planaren Sputtertargets wurde mit einer Sputterleistung von 7 W/cm² und die rohrförmigen Sputtertargets mit einer Sputterleistung von 15 kW/cm² betrieben.

Die Bestimmung der mittleren Korngröße erfolgte mikroskopisch an einem Flachschliff der Sputterseite nach dem Linienschnittverfahren gemäß ASTM E112 an mindestens vier zufällig ausgewählten Proben eines Targets.

Der Sauerstoffgehalt wurde mittels Heißgasextraktion gemessen. Die Verunreinigungen wurden mittels Glow-Discharge-Mass-Spektrometry (GDMS) bestimmt.

Darüber hinaus wurde die Qualität der Targets hinsichtlich des Auftretens von *Micro-arcing* und Spritzern (*splashes*) über das Auswerten des Arcing-Monitors sowie über die optische Bewertung von Testsubstraten durchgeführt. Das Ergebnis hinsichtlich des Auftretens von *Micro-arcing* und *splashes* ist in den Spalten 7 und 8 von Tabelle 1 qualitativ bewertet. Dabei setzt sich die Symbolik der qualitativen Bewertung wie folgt um:

| | |
|---|---|
| ∘ "++" sehr gut, | ∘ "-" schlecht und |
| ∘ "+" gut, | ∘ "--" sehr schlecht. |
| ∘ "0" akzeptabel, | |

**Tabelle 1**

| Versuch Nr. | Zusammensetzung (+ Verunreinigungen) Rest: Silber [Gew.-ppm] | | Sauerstoffgehalt [Gew.-ppm] | Mittlere Korngröße [µm] | Metallische Reinheit [%] | Ergebnis | |
|---|---|---|---|---|---|---|---|
| | | | | | | *Microarcing* | *Splashes* |
| 1 | In | 5.000 | 303 | 100 | 99,95 | - | -- |
| | Al | 1 | | | | | |
| | Mg | 2 | | | | | |
| 2 | In | 5.000 | 3 | 65 | 99,99 | + | ++ |
| | VU | <0,5 | | | | | |
| 3 | In | 5.000 | 15 | 45 | 99,99 | ++ | + |
| | Sn | 5.000 | | | | | |
| | VU | <0,1 | | | | | |
| 4 | In | 5.000 | 30 | 150 | 99,99 | -- | -- |
| | Sn | 5.000 | | | | | |
| | Al | 1 | | | | | |
| | Mg | 2 | | | | | |
| 5 | In | 10.000 | 19 | 50 | 99,99 | ++ | + |
| | VU | <0,1 | | | | | |
| 6 | In | 10.000 | 220 | 50 | 99,95 | -- | -- |
| | Mg | <0,1 | | | | | |
| 7 | In | 2.000 | 120 | 120 | 99,95 | 0 | - |
| | Sb | 10.000 | | | | | |
| | Al | 1 | | | | | |
| | Mg | 2 | | | | | |
| | Cr | <0,1 | | | | | |
| 8 | In | 2.000 | 11 | 75 | 99,99 | + | ++ |
| | Sb | 10.000 | | | | | |
| | VU | <0,5 | | | | | |
| 9 | In | 5.000 | 280 | 200 | 99,99 | -- | -- |
| | Bi | 2.000 | | | | | |
| | Mg | 10 | | | | | |
| | Cr | 3 | | | | | |
| 10 | In | 5.000 | 7 | 80 | 99,99 | 0 | + |
| | Bi | 2.000 | | | | | |
| | VU | <0,5 | | | | | |

Gute Ergebnisse werden nur bei Sputtertargets erhalten, bei denen das Kristallgefüge eine mittlere Korngröße von weniger als 120 µm aufweist und der Sauerstoffgehalt weniger als 20 Gew.-ppm beträgt. Ein Gehalt an Aluminium, Lithium, Natrium, Calcium, Magnesium, Barium und Chrom von jeweils mehr als 0,5 Gew.-ppm verschlechtert das Ergebnis.

## Patentansprüche

1. Planares Sputtertarget mit einer Fläche von mehr als 0,3 m² oder rohrförmiges Sputtertargets mit einer Länge von mindestens 1,0 m, jeweils bestehend aus einer Silberbasislegierung mit mindestens einer weiteren Legierungskomponente ausgewählt aus Indium, Zinn, Antimon und Wismut mit einem Gewichtsanteil von zusammen 0,01 bis 5,0 Gew.-%, **gekennzeichnet durch** ein Kristallgefüge mit einer mittleren Korngröße von weniger als 120 µm, einem Sauerstoffgehalt von weniger als 20 Gew.-ppm, einem Gehalt an Verunreinigungselementen von Aluminium, Lithium, Natrium, Calcium, Magnesium, Barium und Chrom von jeweils weniger als 0,5 Gew.-ppm, und einer metallischen Reinheit von mindestens 99,99 Gew.-%.

2. Sputtertarget nach Anspruch 1, **dadurch gekennzeichnet, dass** die Silberbasislegierung einen Sauerstoffgehalt von weniger als 10 ppm aufweist.

3. Sputtertarget nach Anspruch 1 oder 2, **dadurch gekennzeichnet, dass** der Gehalt von jedem der Verunreinigungselemente weniger als 0,1 ppm beträgt.

4. Sputtertarget nach einem der vorhergehenden Ansprüche, **dadurch gekennzeichnet**, der Gesamtgehalt der genannten Verunreinigungselemente weniger als 0,5 ppm, vorzugsweise weniger als 0,1 ppm beträgt.

5. Sputtertarget nach einem der vorhergehenden Ansprüche, **dadurch gekennzeichnet, dass** die mittlere Korngröße kleiner als 100 µm ist.

6. Verfahren zur Herstellung eines planaren Sputtertargets mit einer Fläche von mehr als 0,3 m² oder eines rohrförmigen Sputtertargets mit einer Länge von mindestens 1,0 m aus einer Silberbasislegierung nach einem der Ansprüche 1 bis 5, umfassend das Schmelzen einer Legierung mit einer nominalen Zusammensetzung von Silber und mindestens einer weiteren Legierungskomponente ausgewählt aus Indium, Zinn, Antimon und Wismut mit einem Gewichtsanteil von zusammen 0,01 bis 5,0 Gew.-%, Gießen der Schmelze in eine Form unter Bildung eines Formkörpers aus der Silberbasislegierung und Umformen des Formkörpers zu dem Sputtertarget, **dadurch gekennzeichnet, dass** das Schmelzen durch Induktionsschmelzen unter reduzierend wirkenden Bedingungen durch Zugabe von Graphitpartikeln zur Schmelze unter Einstellung eines Sauerstoffgehalts von weniger als 20 Gew.-ppm erfolgt, und unter Bildung des Sputtertargets mit einem Kristallgefüge mit einer mittleren Korngröße von weniger als 120 µm, einem Gehalt an Verunreinigungselementen von Aluminium, Lithium, Natrium, Calcium, Magnesium, Barium und Chrom von jeweils weniger als 0,5 Gew.-ppm, und einer metallischen Reinheit von mindestens 99,99 Gew.-%.

7. Verfahren nach Anspruch 6, **dadurch gekennzeichnet, dass** die reduzierend wirkenden Bedingungen durch Anwesenheit von Kohlenstoff erzeugt werden.

8. Verfahren nach Anspruch 6 oder 7, **dadurch gekennzeichnet, dass** das Umformen des Formkörpers aus der Silberbasislegierung bei einer Temperatur im Bereich von 650 bis 750 °C unter dynamischer Rekristallisation des Kristallgefüges und unter Ausbildung einer mittleren Korngröße von weniger als 120 µm erfolgt.

## Claims

1. Planar sputtering target having a surface area of more than 0.3 m³ or tubular sputtering target having a length of at least 1.0 m, each consisting of a silver-based alloy and at least one further alloy component selected from indium, tin, antimony and bismuth with a combined weight fraction of 0.01 to 5.0 wt.%, **characterised by** a crystal structure having a mean grain size of less than 120 µm, an oxygen content of less than 20 ppm by weight, a content of impurity elements of aluminum, lithium, sodium, calcium, magnesium, barium and chromium of less than 0.5 ppm by weight each, and a metallic purity of at least 99.99 wt.%.

2. Sputtering target according to claim 1, **characterized in that** the silver-based alloy has an oxygen content of less than 10 ppm.

3. Sputtering target according to claim 1 or 2, **characterized in that** the content of each of the impurity elements is less than 0.1 ppm.

4. Sputtering target according to one of the preceding claims, **characterized in that** the total content of said impurity elements is less than 0.5 ppm, preferably less than 0.1 ppm.

5. Sputtering target according to one of the preceding claims, **characterized in that** the mean grain size is smaller than 100 µm.

6. Method for producing a planar sputtering target having a surface area of more than 0.3 m³ or a tubular sputtering target having a length of at least 1.0 m from a silver-based alloy according to any of the claims 1 to 5 comprising melting of an alloy having a nominal composition of silver and at least one further alloy component selected from indium, tin, antimony and bismuth with a combined weight fraction of 0.01 to 5.0 wt.%, casting of the melt in a mold under provision of a shaped body of the silver-based alloy and forming the shaped body into the sputtering target, **characterized in that** the melting is carried out by induction melting under reducing conditions by addition of graphite particles to the melt while adjusting an oxygen content of less than 20 ppm by weight, and under provision of the sputtering target having a crystal structure with a mean grain size of less than 120 µm, a content of impurity elements of aluminum, lithium, sodium, calcium, magnesium, barium and chromium of less than 0.5 ppm by weight each and a metallic purity of at least 99.99 wt.%.

7. Method according to claim 6, **characterized in that** the reducing conditions are generated by the presence of carbon.

8. Method according to claim 6 or 7, **characterized in that** the forming of the shaped body of the silver-based alloy is carried out at a temperature in the range of 650 to 750 °C under dynamic recrystallization of the crystal structure and under provision of an average grain size of less than 120 µm.

## Revendications

1. Cible plane pour pulvérisation cathodique, ayant une aire supérieure à 0,3 m², ou cible tubulaire pour pulvérisation cathodique, ayant une longueur d'au moins 1,0 m, chacune étant constituée d'un alliage à base d'argent, présentant au moins un composant d'alliage supplémentaire choisi parmi l'indium, l'étain, l'antimoine et le bismuth, avec une proportion pondérale globale de 0,01 à 5,0 % en poids, **caractérisée par** une structure cristalline présentant une grosseur moyenne des grains inférieure à 120 µm, une teneur en oxygène inférieure à 20 ppm en poids, une teneur en éléments contaminants aluminium, lithium, sodium, calcium, magnésium, baryum et chrome, chacune inférieure à 0,5 ppm en poids, et une pureté métallique d'au moins 99,99 % en poids.

2. Cible pour pulvérisation cathodique selon la revendication 1, **caractérisée en ce que** l'alliage à base d'argent présente une teneur en oxygène inférieure à 10 ppm.

3. Cible pour pulvérisation cathodique selon la revendication 1 ou 2, **caractérisée en ce que** la teneur en chacun des éléments contaminants est inférieure à 0,1 ppm.

4. Cible pour pulvérisation cathodique selon l'une des revendications précédentes, **caractérisée en ce que** la teneur totale en les éléments contaminants mentionnés est inférieure à 0,5 ppm, de préférence inférieure à 0,1 ppm.

5. Cible pour pulvérisation cathodique selon l'une des revendications précédentes, **caractérisée en ce que** la grosseur moyenne des grains est inférieure à 100 µm.

6. Procédé de fabrication d'une cible plane pour pulvérisation cathodique ayant une aire supérieure à 0,3 m² ou d'une cible tubulaire pour pulvérisation cathodique ayant une longueur d'au moins 1,0 m, constituée d'un alliage à base d'argent selon l'une des revendications 1 à 5, comprenant la fusion d'un alliage présentant une composition nominale d'argent et d'au moins un composant d'alliage supplémentaire choisi parmi l'indium, l'étain, l'antimoine et le bismuth, avec une proportion pondérale globale de 0,01 à 5,0 % en poids, coulée de la masse fondue dans un moule avec formation d'un objet moulé en l'alliage à base d'argent, et transformation de l'objet moulé en la cible pour pulvérisation cathodique, **caractérisé en ce que** la fusion a lieu par fusion par induction dans des conditions réductrices, par addition de particules de graphite à la masse fondue et avec ajustement d'une teneur en oxygène inférieure à 20 ppm en poids, et avec formation d'une cible pour pulvérisation cathodique présentant une structure cristalline ayant une grosseur moyenne des grains inférieure à 120 µm, une teneur en éléments contaminants aluminium, lithium, sodium, calcium, magnésium, baryum et chrome, chacune inférieure à 0,5 ppm en poids, et une pureté métallique d'au moins 99,99 % en poids.

7. Procédé selon la revendication 6, **caractérisé en ce que** les conditions réductrices sont produites par la présence de carbone.

8. Procédé selon la revendication 6 ou 7, **caractérisé en ce que** la transformation de l'objet moulé en l'alliage à base d'argent s'effectue à une température comprise dans la plage de 650 à 750 °C en présence d'une recristallisation dynamique de la structure cristalline, et avec formation d'une grosseur moyenne des grains inférieure à 120 µm.
